# FASCICULE DE BREVET EUROPEEN

(11) **EP 3 772 074 B1**
(45) Date de publication et mention de la délivrance du brevet: **10.11.2021**
(21) Numéro de dépôt: 20182821.7
(22) Date de dépôt: 29.06.2020
(51) Int. Cl.: H01H 3/20, H01H 13/48

(54) **ENSEMBLE COMPORTANT UN COMMUTATEUR ÉLECTRIQUE NORMALEMENT OUVERT ET UNE LAME DE COMMANDE DE SON CHANGEMENT D'ÉTAT QUI LE MAINTIENT FERMÉ AU REPOS**
EINHEIT, DIE EINEN NORMALERWEISE OFFENEN ELEKTRISCHEN SCHALTER UND EINE ZUNGE ZUR STEUERUNG SEINER ZUSTANDSVERÄNDERUNG UMFASST, DIE IHN IM RUHEZUSTAND GESCHLOSSEN HÄLT
ASSEMBLY COMPRISING A NORMALLY OPEN ELECTRIC SWITCH AND A BLADE FOR CONTROLLING ITS CHANGE OF STATE THAT KEEPS IT CLOSED WHEN NON-OPERATIVE

(30) Priorité: 01.08.2019 FR 1908812
(43) Date de publication de la demande: 03.02.2021
(73) Titulaire: C&K Components SAS, 39100 Dole (FR)
(72) Inventeur: GAUTHIER, Philippe, 25440 Liesle (FR); MAYOT, Jocelyn, 39100 Sampans (FR); VALCHER, Fabrice, 39100 Dole (FR); KUBAT, Laurent, 39100 Dole (FR)
(74) Mandataire: Novagraaf Technologies

(56) Documents cités:
- FR-A- 1 398 769
- FR-A1- 2 720 865
- GB-A- 2 535 977

## Description

### Domaine technique de l'invention

L'invention concerne un ensemble comportant un commutateur électrique - du type normalement ouvert - comportant un organe de déclenchement et une lame associée, déformable élastiquement, de commande du changement d'état du commutateur électrique en réponse à l'application d'un effort d'actionnement sur la lame de commande, dans lequel, en l'absence d'application d'un effort d'actionnement le commutateur électrique est maintenu dans un état fermé.

### Arrière-plan technique

Un tel ensemble est connu du document FR-A1-2.720.865 dans lequel, selon le premier mode de réalisation qui y est décrit et illustré aux figures 1 et 2, il comporte :
- un commutateur électrique comportant un organe de déclenchement 26 ; et
- une lame 32 déformable élastiquement de commande du changement d'état du commutateur électrique en réponse à l'application d'un effort d'actionnement sur la lame de commande, ensemble dans lequel la lame de commande comprend :
   -- une branche 36 pour la fixation de la lame de commande par rapport à l'organe de déclenchement 26 ;
   -- une branche d'actionnement 40 dont une extrémité arrière est reliée à la branche de fixation 36 et qui, en l'absence d'application d'un effort d'actionnement, sollicite l'organe 26 de déclenchement du commutateur électrique dans un sens correspondant à la fermeture du commutateur ; et
   -- une branche de commande 34 qui est reliée à la branche d'actionnement 40 et qui, sous l'application d'un effort d'actionnement qui lui est appliqué par un organe 10 d'actionnement, pivote (autour d'un axe X-X orthogonal à la direction d'actionnement de l'organe de déclenchement 26) pour provoquer un basculement de la branche d'actionnement 40 à l'encontre de son élasticité pour maintenir le commutateur électrique dans un état libre ouvert.

Dans ce document, l'ensemble est intégré à un dispositif de lecture-écriture des données contenues dans une carte à mémoire électronique et, en l'absence d'une carte en position de lecture agissant sur la branche de commande, le commutateur électrique, et notamment son organe de déclenchement, est maintenu sous charge par la branche d'actionnement.

C'est notamment le cas lorsque après la fabrication de l'ensemble et son intégration dans un appareil électronique ou électromécanique - et avant la première utilisation ou mise en marche fonctionnelle de l'appareil - ce dernier est stocké pendant une période pouvant être très longue, jusqu'à sa livraison et la première utilisation provoquant au moins un premier changement d'état du commutateur électrique pour que ce dernier retrouve au moins temporairement son état libre ouvert sans charge, ou quasiment sans charge sur son organe de déclenchement.

L'invention vise à apporter une solution à ce problème

### Résumé de l'invention

L'invention propose un ensemble comportant :
- un commutateur électrique comportant un organe de déclenchement dont les changements d'état provoquent un changement d'état du commutateur électrique entre un état libre ouvert et un état actionné fermé; et
- une lame déformable élastiquement de commande du changement d'état du commutateur électrique en réponse à l'application d'un effort d'actionnement sur la lame de commande, ensemble dans lequel la lame de commande comprend :
   -- une branche pour la fixation de la lame de commande par rapport à l'organe de déclenchement ;
   -- une branche d'actionnement dont une extrémité arrière est reliée à la branche de fixation et qui, en l'absence d'application d'un effort d'actionnement, sollicite l'organe de déclenchement du commutateur électrique dans un sens correspondant à la fermeture du commutateur électrique ; et
   -- une branche de commande qui est reliée à la branche d'actionnement et qui, sous l'application d'un effort d'actionnement qui lui est appliqué par un organe d'actionnement, pivote autour d'un axe orthogonal à la direction d'actionnement de l'organe de déclenchement pour provoquer un basculement de la branche d'actionnement à l'encontre de son élasticité pour maintenir le commutateur électrique dans un état libre ouvert, caractérisé en ce que l'ensemble comporte un dispositif de verrouillage de la lame de commande dans une position initiale de livraison de l'ensemble dans laquelle la branche d'actionnement ne sollicite pas l'organe de déclenchement du commutateur électrique qui est dans son état ouvert.

Selon d'autres caractéristiques de l'ensemble selon l'invention :
- le déverrouillage de la lame de commande est provoqué lors d'une première application d'un effort d'actionnement sur la lame de commande ;
- le dispositif de verrouillage verrouille la branche de commande de la lame de commande dans une position angulaire initiale de livraison de l'ensemble dans laquelle la branche d'actionnement ne sollicite pas l'organe de déclenchement du commutateur électrique qui est dans son état ouvert ; et le déverrouillage de la branche de commande est provoqué lors d'une première application d'un effort d'actionnement sur la branche de commande ;

- la branche de commande s'étend, selon une direction longitudinale, depuis une extrémité avant de la branche d'actionnement ; et le dispositif de verrouillage verrouille une extrémité libre opposée de la branche de commande ;
- le dispositif de verrouillage comporte une languette escamotable de verrouillage qui comporte un trou (formant gâche) dans lequel est reçue ladite extrémité libre de la branche de commande (formant pêne) lorsque cette dernière est dans sa position angulaire initiale de livraison, et la languette de verrouillage comporte un bec de commande de son déverrouillage sur lequel l'organe d'actionnement agit lors d'une première application d'un effort d'actionnement pour libérer ladite extrémité libre ;
- la languette de verrouillage est réalisée en une seule pièce avec la lame de commande ;
- la branche de commande s'étend longitudinalement d'avant vers l'arrière au-dessus de la branche d'actionnement ;
- la branche de commande est une branche rigide formant levier de commande du basculement de la branche d'actionnement ;
- le commutateur électrique comporte un boîtier qui loge ledit organe de déclenchement et qui est apte à être fixé sur un support, notamment sur une plaque à circuits imprimés ;
- la branche de fixation de la lame de commande est fixée au boitier du commutateur électrique ou est apte à être fixée sur ladite plaque à circuits imprimés ;
- le commutateur électrique comporte un poussoir d'actionnement de l'organe de déclenchement, et un organe, distinct de l'organe de déclenchement, de rappel élastique de l'organe de déclenchement vers une position de repos dans laquelle le commutateur électrique est dans son état libre ouvert.

L'invention propose aussi un agencement d'un ensemble selon l'invention pour l'actionnement du commutateur électrique, caractérisé en ce qu'il comporte un organe d'actionnement qui est mobile par rapport à la branche de commande, successivement entre :
- une position de repos ;
- une position intermédiaire dans laquelle il coopère avec le dispositif de verrouillage pour, si nécessaire, provoquer le déverrouillage de la lame de commande ; et
- une position active dans laquelle la lame de commande maintient le commutateur électrique dans son état ouvert.

### Brève description des figures

D'autres caractéristiques et avantages de l'invention apparaitront au cours de la lecture de la description détaillée qui va suivre pour la compréhension de laquelle on se reportera aux dessins annexés dans lesquels :
[Fig.1] - la figure 1 est une vue en perspective d'un exemple de réalisation selon l'invention qui est illustré dans un état initial dit « verrouillé » de la branche de commande de la lame de commande ;
[Fig.2] - la figure 2 est une vue en perspective éclatée des principaux composants de l'ensemble illustré à la figure 1 ;
[Fig.3] - la figure 3 est une vue de côté de l'ensemble illustré à la figure 1 ;
[Fig.4] - la figure 4 est une vue en coupe, par un plan vertical et longitudinal médian, de l'ensemble illustré à la figure 1
[Fig.5] - la figure 5 est une vue en perspective à plus grande échelle de la lame de commande illustrée à la figure 1 ;
[Fig.6] - la figure 6 est une vue de dessus à plus grande échelle de la lame de commande illustrée à la figure 1 ;
[Fig.7] - la figure 7 est une vue latérale à plus grande échelle de la lame de commande illustrée aux figures précédentes qui est représentée en association avec un organe d'actionnement en position de repos ;
[Fig.8] - la figure 8 est une vue analogue à celle de la figure 3 sur laquelle l'ensemble est illustré dans un état dit « relâché » de la branche de commande de la lame de commande, après déverrouillage de la branche de commande, et qui est représenté en association avec l'organe d'actionnement en position de repos ;
[Fig.9] - la figure 9 est une vue en coupe, par un plan vertical et longitudinal médian, de l'ensemble illustré à la figure 8;
[Fig.10] - la figure 10 est une vue analogue à celle de la figure 8 sur laquelle l'ensemble est illustré dans un état dit « actionné » de la branche de commande de la lame de commande, sous l'effet de l'effort d'actionnement qui lui est appliqué par l'organe d'actionnement en position active dans laquelle la lame de commande maintient le commutateur électrique dans son état ouvert ;
[Fig. 11] - la figure 11 est une vue en coupe, par un plan vertical et longitudinal médian, de l'ensemble illustré à la figure 10.

### Description détaillée de l'invention

Pour la description de l'invention et la compréhension des revendications, on adoptera à titre non limitatif et sans référence limitative à la gravité terrestre les orientations verticale, longitudinale et transversale selon le repère V, L, T indiqué aux figures dont les axes longitudinal L et transversal T s'étendent dans un plan horizontal.

Par convention, l'axe longitudinal L est orienté de l'arrière vers l'avant, ici de la droite vers la gauche en considérant les figures.

Dans la description qui va suivre, des éléments identiques, similaires ou analogues seront désignés par les mêmes chiffres de référence.

Dans la description qui va suivre, l'ensemble présente une symétrie générale de conception par rapport au plan vertical et longitudinal médian PVL.

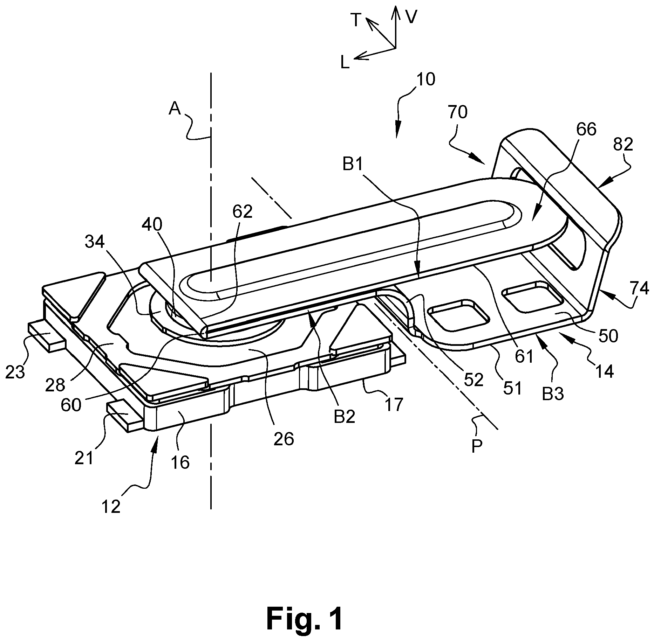

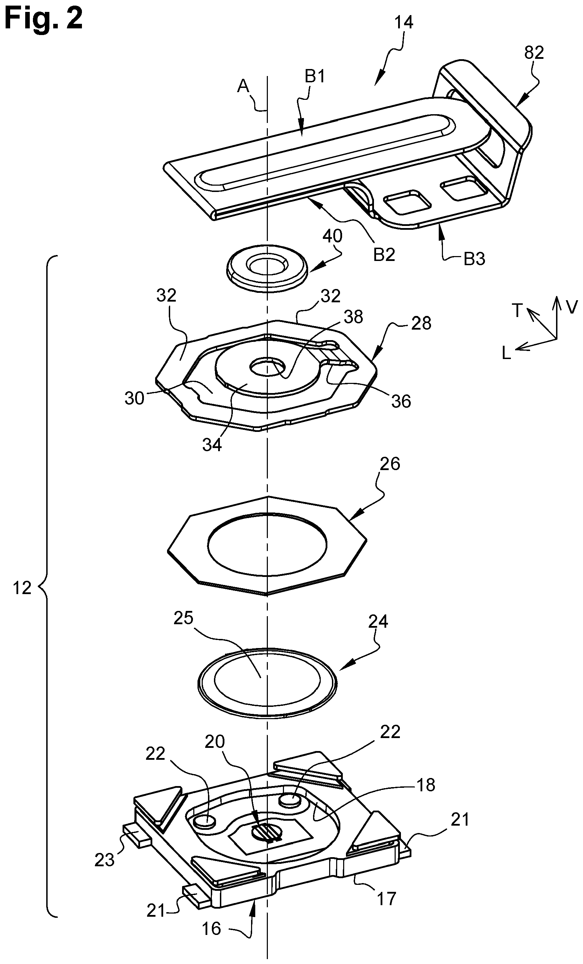

### Etat verrouillé de la branche de commande et commutateur électrique dans son état libre ouvert - figures 1 à 7

La présente invention concerne un ensemble 10 comportant essentiellement un commutateur électrique 12 et une lame de commande 14 pour l'actionnement indirect du commutateur électrique 12.

Conformément à la conception illustrée aux figures, le commutateur électrique 12 est du type dit normalement ouvert (Type NO) c'est-à-dire un commutateur électrique dans lequel, en l'absence d'un effort d'actionnement suffisant appliqué au commutateur électrique, la voie de commutation est interrompue ou ouverte tandis que, en réponse à l'application d'un effort d'actionnement suffisant, le commutateur électrique 12 est fermé et la voie de commutation est établie.

Le commutateur électrique 12 comporte essentiellement un boîtier 16 inférieur en matériau isolant, ici de forme parallélépipédique carrée, qui délimite un logement interne 18 dans le fond duquel sont agencés au moins deux contacts électriques fixes central 20 et périphérique 22 dont chacun est relié électriquement à une borne associée 21, 23 de raccordement électrique agencée à l'extérieur du boîtier 16.

De manière connue, un organe de déclenchement 24 en matériau conducteur est logé dans le logement interne 18 et il est ici réalisé en forme d'un dôme en forme de calotte sphérique de contour circulaire dont la convexité est orientée verticalement vers le haut.

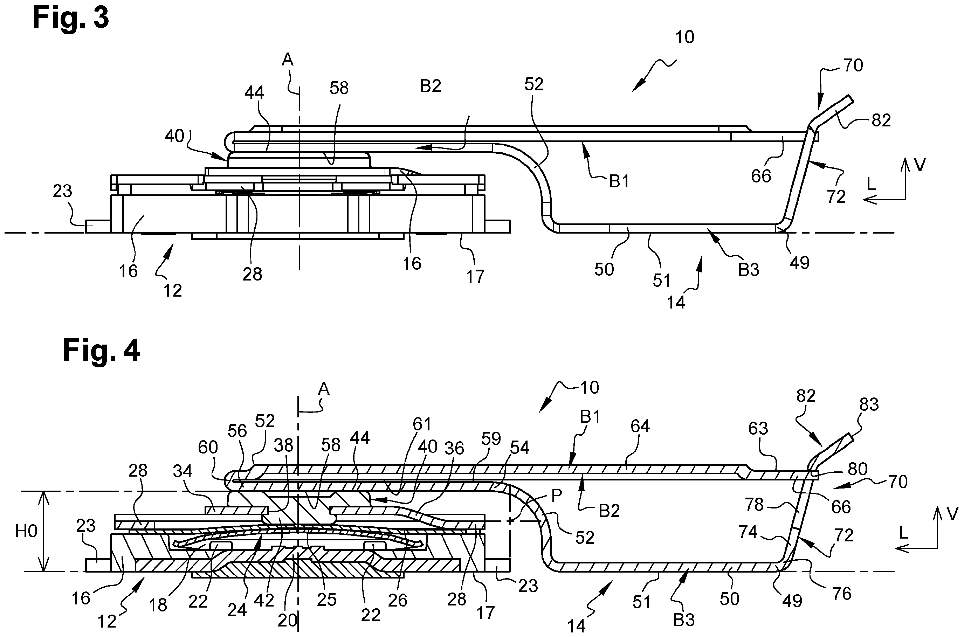

Dans son état de repos illustré à la figure 4, le sommet 25 de l'organe de déclenchement 24 est situé verticalement au-dessus du contact fixe central 20 et aucune voie de commutation n'est établie entre les deux contacts fixes 20 et 22.

Lorsqu'un effort d'actionnement de valeur suffisante est appliqué sur le sommet 25 de l'organe de déclenchement 24 selon l'axe A d'actionnement d'orientation verticale, l'organe de déclenchement 24 change d'état et est déformé pour, de manière connue, établir une voie de commutation électrique entre les deux contacts fixes 20 et 22 et donc entre les bornes de raccordement 21 et 23.

Le boîtier 16, avec ses bornes de raccordement 21 et 23, est ici conçu de manière à pouvoir être fixé sur la face supérieure d'une plaque à circuits imprimés (non représentée), par exemple selon la technique dite CMS.

Le commutateur électrique 12 comporte ici un film adhésif d'étanchéité 26 qui ferme de manière étanche le logement interne 18 avec l'organe de déclenchement 24 agencé à l'intérieur.

Pour l'actionnement du commutateur électrique 12 et de l'organe de déclenchement 24, le commutateur électrique 12 comporte ici, à titre d'exemple non limitatif, une plaque ou cage supérieure de contour annulaire 28 qui est par exemple fixée au boîtier inférieur 16 par sertissage du corps de ce dernier autour des portions d'angle 32 de la plaque supérieure 28.

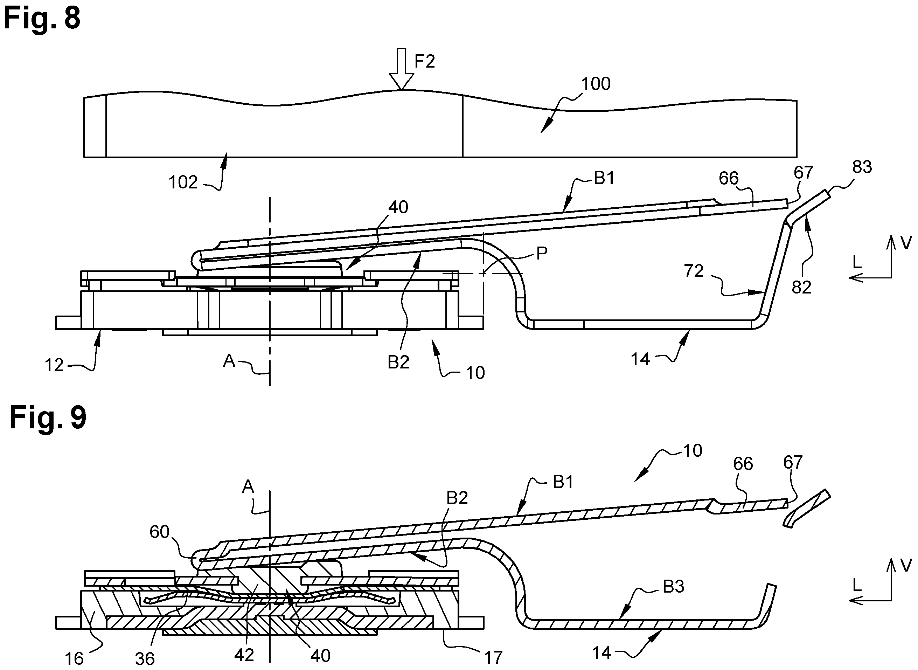

Dans sa partie centrale 30, la plaque supérieure 28 comporte un anneau central 34 qui lui est relié par une patte déformable élastiquement de liaison 36 de telle manière que cette dernière puisse être déplacée verticalement vers le bas à partir de sa position de repos haute, illustrée à la figure 4, jusqu'à une position basse d'actionnement illustrée à la figure 9, et ceci à l'encontre de l'effort de rappel élastique vers sa position haute de repos qui est appliqué à l'anneau central 34 par la patte de liaison 36.

La plaque supérieure 28 avec son anneau central 34 est ici réalisée en une seule pièce en métal par découpe et cambrage.

L'orifice central 38 de l'anneau central 34 loge un poussoir 40 d'actionnement dont l'extrémité inférieure 42 coopère avec une portion en vis-à-vis de la face supérieure externe de la partie centrale ou sommet de l'organe de déclenchement 24.

Le poussoir 40 est par exemple réalisé par surmoulage sur l'anneau central 34.

La face supérieure libre 44 du poussoir 40 est ici de forme annulaire plane et horizontale.

Dans la position haute de repos du poussoir 40, sa face supérieure libre 44 est située à une cote "H0" du plan de la face inférieure horizontale 17 du boîtier 16 (Voir Figure 4).

La lame de commande 14 est une pièce déformable élastiquement réalisée ici en une feuille de métal découpée et pliée.

La lame de commande 14 s'étend globalement selon une direction longitudinale avec une partie inférieure arrière de fixation, une partie supérieure avant fonctionnelle et une partie arrière de verrouillage.

Plus précisément et à titre non limitatif, la lame de commande 14 comporte ici une branche supérieure plane B1 de commande, une branche supérieure adjacente plane B2 d'actionnement, et une branche inférieure plane et horizontale B3 de fixation.

La branche inférieure de fixation B3 comporte un tronçon principal de fixation 50 plan et horizontal qui s'étend longitudinalement d'arrière vers l'avant et qui se prolonge, vers l'avant et vers le haut, par un tronçon 52 coudé à 90 degrés de raccordement et « d'articulation ».

Le tronçon principal de fixation 50 est par exemple conçu pour permettre la fixation de la lame de commande 14 sur la face supérieure de la plaque à circuits imprimés sur laquelle est soudée le boitier 16 du commutateur électrique 12 avec ainsi la face inférieure 51 du tronçon principal de fixation 50 dans le même plan que celui de la face inférieure 17 du boîtier 16.

A partir de l'extrémité supérieure avant 54 du tronçon de raccordement 52, la branche de fixation B3 se prolonge par la branche d'actionnement B2.

La branche d'actionnement B2 est une branche plane continue qui s'étend longitudinalement d'arrière vers l'avant depuis l'extrémité 54 jusqu'à une extrémité avant 56.

Dans l'état verrouillé illustré aux figures 1 à 7, la branche d'actionnement B2 s'étend sensiblement horizontalement parallèlement au tronçon principal de fixation 50 et, au voisinage de son extrémité avant 56, la face inférieure 58 de la branche d'actionnement B2 est en appui plan sans jeu sur la face supérieure annulaire 44 du poussoir 40.

Toutefois, dans cet état verrouillé, la branche d'actionnement B1 n'exerce pas un effort d'actionnement sur l'organe de déclenchement 24 et le commutateur électrique 12 est maintenu dans son état libre ouvert.

La branche supérieure de commande B1 est une branche plane continue qui s'étend longitudinalement d'avant vers l'arrière depuis une extrémité avant 62.

La branche supérieure de commande B1 comporte une nervure longitudinale supérieure de renfort 64 qui lui confère une grande rigidité et une quasi indéformabilité au regard des efforts qui lui sont appliqués.

L'extrémité avant 62 de la branche de commande B1 est ici reliée à l'extrémité avant 56 de la branche d'actionnement B2 par un coude à 180 degrés 60.

La branche de commande B1 est ainsi « repliée » au-dessus de la branche d'actionnement B2 avec sa face inférieure 61 adjacente à la face supérieure 59 de la branche d'actionnement B2.

La face supérieure 63 de la branche de commande B1 qui entoure la nervure centrale 64 est plane.

La branche de commande B1 se termine par un tronçon 66 d'extrémité libre arrière 66, ici de contour semi-circulaire.

Dans l'état verrouillé illustré aux figures 1 à 7, la branche de commande B1 s'étend sensiblement horizontalement parallèlement à la branche d'actionnement B2 et au tronçon principal de fixation 50.

La branche de commande B1, et notamment son tronçon d'extrémité libre arrière 66, s'étend longitudinalement vers l'arrière au-dessus de la branche de fixation B3, et notamment au-delà de l'extrémité arrière 49 du tronçon principal de fixation 50.

L'invention n'est pas limitée au mode de réalisation décrit selon lequel les branches de commande B1, d'actionnement B2 et de fixation B3 sont globalement superposées. A titre de variante non représentée, les branches de commande et d'actionnement peuvent s'étendre dans le prolongement longitudinal l'une de l'autre et la branche de fixation peut être réalisée sous la forme de deux branches latérales opposées situées de part et d'autre de la branche de commande.

L'ensemble 10 comporte des moyens de verrouillage de la branche de commande B1 et de la branche d'actionnement B2 dans l'état verrouillé illustré aux figures 1 à 7 qui sont constitués par un dispositif 70 de verrouillage de la lame de commande 14. A titre d'exemple non limitatif, les moyens de verrouillage sont ici réalisés en une seule pièce avec la lame de commande 14.

A cet effet, au-delà de son extrémité longitudinale arrière 49, le tronçon principal horizontal de fixation 50 la branche de fixation B3 se prolonge par une languette de verrouillage 72 qui s'étend globalement vers le haut en étant ici légèrement inclinée vers l'arrière par rapport à la verticale.

La languette de verrouillage 72 est une languette escamotable par déformation élastique.

Le tronçon principal 74 de la languette de verrouillage 72 est en forme d'une plaque plane qui est reliée à l'extrémité 49 par un coude 76 de raccordement et « d'articulation ».

Dans sa partie centrale, le tronçon principal 74 de la languette de verrouillage 72 comporte un trou central 78 d'orientation transversale qui est notamment délimité par un bord supérieur transversal et horizontal 80.

Le trou central 78 constitue la gâche du dispositif de verrouillage 70 et le tronçon d'extrémité libre arrière 66 de la branche de commande B1 en constitue le pêne associé.

Ainsi, dans la position verrouillée illustrée aux figures 1 à 7, le tronçon d'extrémité libre 66 est reçu dans le trou 78 et il est sollicité élastiquement vers le haut de telle manière que sa face supérieure est en appui élastique contre le bord supérieur 80.

Ainsi, le dispositif de verrouillage détermine la position et l'orientation occupée par la branche de commande B1 et la branche d'actionnement B2, par rapport au commutateur électrique.

Afin de pouvoir déverrouiller la branche de commande B1 et libérer ainsi la lame de commande 14 en vue de son utilisation pour commander des changements d'état du commutateur électrique 12, la languette de verrouillage 74 comporte un bec 82 de commande du déverrouillage qui est agencé à l'extrémité supérieure du tronçon principal 74.

Le bec de commande 82 est délimité par un bord supérieur libre 83 et il est incliné vers l'arrière de manière à présenter une face supérieure 84 inclinée à environ 45 degrés par rapport à la verticale.

Dans la position verrouillée, le bec de commande 82 et son bord supérieur 83 s'étendent verticalement au-dessus du plan horizontal correspondant à la face supérieure 63 de la branche de commande B1

Le tronçon principal 74 et le bec de commande 82 forment une languette globalement rigide qui est susceptible de pivoter autour d'un axe horizontal transversal correspondant sensiblement au coude 49, en réponse à un effort de commande du déverrouillage appliqué au bec de commande 82, et notamment sur le bord supérieur 83 et/ou sur la face supérieure 84.

De par son élasticité, la languette de verrouillage est rappelée vers sa position de repos et de verrouillage illustrée aux figures 1 à 7.

La commande du déverrouillage consiste, en agissant sur le bec de commande 82, à faire pivoter la languette de verrouillage dans le sens horaire autour du coude 49, au moins jusqu'à provoquer l'échappement du tronçon d'extrémité libre 66 de la branche de commande B1 hors du trou central 78.

Loque l'on cesse d'appliquer l'effort de déverrouillage sur le bec de commande 82, et donc sur la languette de verrouillage 72, la languette de verrouillage 72 revient dans sa position initiale de repos et de verrouillage, mais la branche de commande B1, et ainsi la lame de commande 14, demeure dans un état déverrouillé et relâché (Voir figures 8 et 9)

A titre de variante non représentée, le changement de position angulaire de la languette de verrouillage 72 à partir de sa position ou état initial de repos et de verrouillage peut être effectué par une déformation plastique au niveau du coude de raccordement 49.

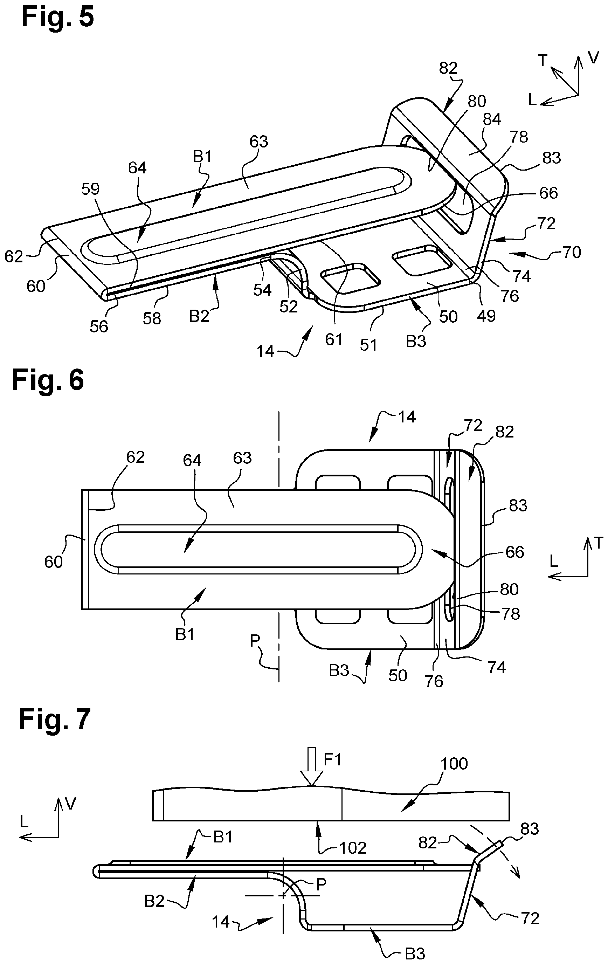

Comme cela est illustré schématiquement à la figure 7, pour agir sur le bec de commande 82 et donc sur la languette de verrouillage 72, et ultérieurement sur la branche de commande B1 « déverrouillée », il est proposé d'agir sur l'ensemble 10 au moyen d'un seul organe d'actionnement 100.

A titre non limitatif et dans l'exemple illustré aux figures 7, 8, 10 et 11, l'organe d'actionnement 100 est apte à se déplacer verticalement dans les deux sens par rapport à l'ensemble 10 et il est délimité par une face inférieure plane horizontale 102.

L'organe d'actionnement 100 est ainsi susceptible d'appliquer un premier effort « F1 » verticalement de haut en bas sur l'ensemble 10.

Comme on peut le comprendre en considérant la figure 7, une première course d'actionnement de l'organe d'actionnement 100 vers le bas va provoquer la coopération d'une portion de la face inférieure 102 avec le bec de commande 82 pour provoquer le pivotement de la languette de verrouillage 74 et le déverrouillage de branche de commande B1 (Voir figure 7).

Si l'effort F1 est relâché, la branche de commande occupe son état déverrouillé et relâché qui va maintenant être décrit en référence aux figures 8 et 9.

### Etat déverrouillé et relâché de la branche de commande et commutateur électrique fermé sous charge - figures 8 et 9

Lorsque la lame de commande 14 est dans son état déverrouillé et relâché illustré aux figures 8 et 9, du fait de son élasticité propre et de l'effet de rappel élastique exercé notamment par le coude de raccordement 52, les branches adjacentes B1 de commande et B2 d'actionnement occupent la position angulaire illustré qui correspond à un basculement ou pivotement, dans le sens antihoraire autour de l'axe de pivotement P, par rapport à l'état verrouillé illustré aux figures 1 à 7.

Ainsi, le bord libre 67 du tronçon d'extrémité libre 66 de la branche de commande B1 est situé verticalement au-dessus du plan dans lequel est situé le bord supérieur libre 83 du bec 82 de commande du déverrouillage.

Du fait de son basculement et de la charge élastique à laquelle elle est soumise, dans son état aux figures 8 à 9, la branche d'actionnement B2 est inclinée par rapport au tronçon principal de fixation 50 et, au voisinage de son extrémité avant 56, la face inférieure 58 de la branche d'actionnement B2 est en appui sans jeu sur la face supérieure annulaire 44 du poussoir 40.

Par l'intermédiaire de la branche d'actionnement B2, la lame de commande 14 exerce ainsi en permanence un effort d'actionnement sur le poussoir 40 et à travers ce dernier sur l'organe de déclenchement 24 qui provoque le changement d'état de ce dernier, et donc du commutateur électrique 12, qui est alors maintenu dans un état fermé dans lequel la voie de commutation électrique entre les bornes de raccordement 21 et 23 est établie.

A partir de cet état ou position, si comme cela est illustré schématiquement à la figure 8, on applique un nouvel effort F2 d'actionnement au moyen de l'organe d'actionnement 100, une portion de la face inférieure 102 de ce dernier va venir coopérer avec le bord d'extrémité libre arrière 67 puis avec la face supérieure de la branche de commande B1.

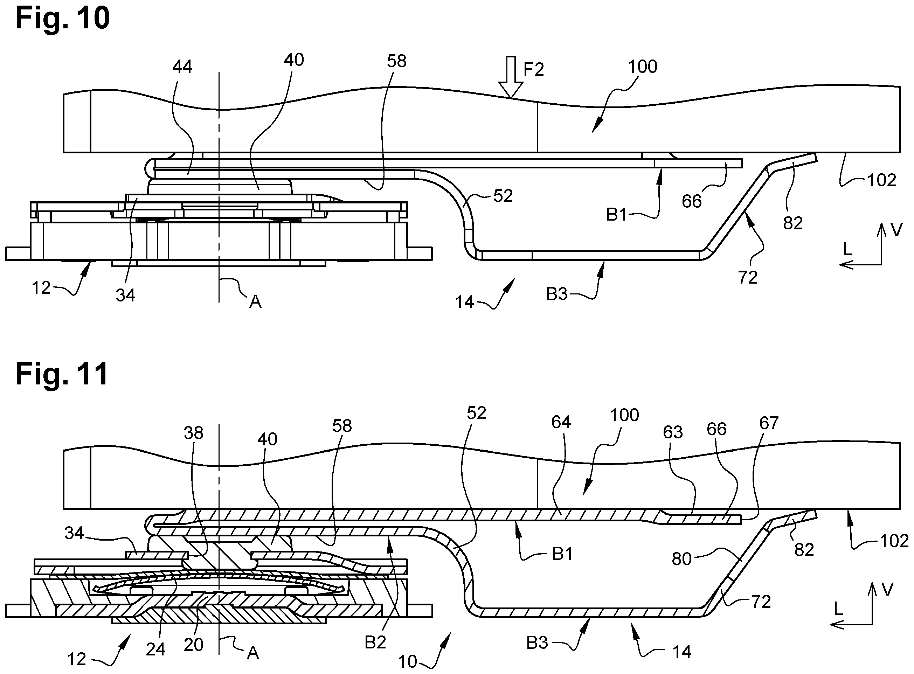

Ainsi, à l'encontre de l'effort de rappel élastique appliqué par le coude 52 aux branches adjacentes B1 de commande et B2 d'actionnement, l'organe d'actionnement 100 poursuit sa course jusqu'à atteindre l'état ouvert du commutateur électrique 12 qui sera décrit en référence aux figures 10 et 11.

Cet état actionné illustré aux figures 10 et 11 - dans lequel le commutateur électrique 12 est ouvert - est maintenu tant qu'un effort d'actionnement F2 de valeur suffisante est appliqué à la branche de commande B1.

Si l'effort d'actionnement est relâché, la branche de commande B1 occupe à nouveau son état déverrouillé et relâché illustré aux figures 8 et 9.

Par ailleurs, en considérant les figures 8 à 10, l'agencement géométrique et dimensionnel de la languette de déverrouillage 72 par rapport à la branche de commande B1 est tel que la course d'actionnement de l'organe d'actionnement 100 provoque aussi une action sur la languette de déverrouillage 74 dans le sens du déverrouillage en supprimant ainsi tout risque de « re-verrouillage » accidentel de la branche de commande B1 lorsque l'effort d'actionnement est relâché.

### Etat actionné de la branche de commande et commutateur électrique dans son état libre ouvert - figures 10 et 11

Lorsque l'organe d'actionnement 100 est dans sa position active basse illustrée aux figures 10 et 11, les branches de commande B1 et d'actionnement B2 sont à nouveau dans la position angulaire qu'elles occupaient initialement (avant leur déverrouillage) dans laquelle elles sont horizontales et elles n'agissent plus sur le poussoir 40.

Dans cet état la branche d'actionnement B2 s'étend horizontalement parallèlement au tronçon principal de fixation 50 et, au voisinage de son extrémité avant 56, la face inférieure 58 de la branche d'actionnement B2 est en appui plan sans jeu sur la face supérieure annulaire 44 du poussoir 40.

La branche d'actionnement B1 n'exerce pas d'effort d'actionnement sur l'organe de déclenchement 24 et le commutateur électrique 12 est maintenu dans son état libre ouvert.

On a ainsi provoqué un changement d'état du commutateur électrique 12 depuis son état fermé (Figure 9) jusqu'à son état libre ouvert (Figure 11).

Lorsque l'application de l'effort d'actionnement est interrompue, la lame de commande 14, et notamment les branches de commande B1 et d'actionnement B2 reviennent dans l'état illustré aux figures 8 et 9 en provoquant un nouveau changement d'état du commutateur électrique 12 depuis son état ouvert (Figure 11) jusqu'à son état fermé (Figure 9).

En variante, un organe d'actionnement peut agir et exercer successivement un effort sur le bec de commande, puis des efforts d'actionnement sur la branche de commande B1 selon une autre direction d'actionnement, et par exemple selon la direction horizontale.

Lorsque le changement de position angulaire de la languette de verrouillage 72 à partir de sa position ou état initial de repos et de verrouillage est obtenu par une déformation élastique au niveau du coude de raccordement 49 et que la patte de verrouillage reprend automatiquement sa position initiale de repos, la conception selon l'invention permet avantageusement de mettre en œuvre un procédé de test de l'ensemble et du commutateur électrique, notamment après qu'il ait été par exemple soudé sur la face supérieure d'une plaque à circuits imprimés.

Ce test vise à vérifier la qualité de la fixation, des raccordements électriques et le bon fonctionnement du commutateur électrique, et notamment ses changements d'états fermé ou ouvert.

La procédure de test permet aussi au client final ayant intégré l'ensemble dans un dispositif ou appareil à commander au moyen de l'ensemble, d'en tester le bon fonctionnement, puis de verrouiller à nouveau la lame de commande.

Ce procédé de test de l'ensemble et du commutateur consiste à :
- a) fabriquer un ensemble 10 selon l'invention ;
- b) fixer un tel ensemble 10 sur une face supérieure d'un sous-ensemble, par exemple sur la face supérieure d'une plaque à circuits imprimés, dans un état dans lequel la lame de commande 14 est dans sa position initiale de livraison ;
- c) agir sur la lame de commande 14 en lui appliquant un effort d'actionnement pour provoquer le déverrouillage de la lame de commande 14 et provoquer un changement d'état du commutateur électrique 12 ;
- d) effectuer des opérations de test du bon fonctionnement de l'ensemble 10, du commutateur électrique 12, et/ou d'un appareil (non représenté) équipé de l'ensemble 10 pour en commander au moins une fonction ;
- e) procéder à nouveau au verrouillage de la lame de commande 14 dans sa position initiale de livraison de l'ensemble 10.

## Revendications

1. Ensemble (10) comportant :
- un commutateur électrique (12) comportant un organe de déclenchement (24) ; et
- une lame (14) déformable élastiquement de commande du changement d'état du commutateur électrique (12) en réponse à l'application d'un effort d'actionnement (F2) sur la lame de commande (14),
et dans lequel (10) la lame de commande (14) comprend :
-- une branche (B3) pour la fixation de la lame de commande (14) par rapport à l'organe de déclenchement (24) ;
-- une branche d'actionnement (B2) dont une extrémité arrière (54) est reliée à la branche de fixation (B3) et qui, en l'absence d'application d'un effort d'actionnement, sollicite l'organe de déclenchement (24) du commutateur électrique (12) dans un sens correspondant à la fermeture du commutateur électrique (12) ; et
-- une branche de commande (B1) qui est reliée à la branche d'actionnement (B2) et qui, sous l'application d'un effort d'actionnement (F2) qui lui est appliqué par un organe d'actionnement (100), pivote autour d'un axe (P) orthogonal à la direction (A) d'actionnement de l'organe de déclenchement (24) pour provoquer un basculement de la branche d'actionnement (B2) à l'encontre de son élasticité pour maintenir le commutateur électrique (12) dans un état libre ouvert,
**caractérisé en ce que** l'ensemble (10) comporte un dispositif de verrouillage (70) de la lame de commande (14) dans une position initiale de livraison de l'ensemble (10) dans laquelle la branche d'actionnement (B2) ne sollicite pas l'organe de déclenchement (24) du commutateur électrique (12) qui est dans son état ouvert.

2. Ensemble (10) selon la revendication 1, **caractérisé en ce que** le déverrouillage de la lame de commande (14) est provoqué lors d'une première application d'un effort d'actionnement (F1) sur la lame de commande (14).

3. Ensemble (10) selon la revendication 2, **caractérisé en ce que** :
- le dispositif de verrouillage (70) verrouille la branche de commande (B1) de la lame de commande (14) dans une position angulaire initiale de livraison de l'ensemble (10) dans laquelle la branche d'actionnement (B2) ne sollicite pas l'organe de déclenchement (24) du commutateur électrique (12) qui est dans son état ouvert ; et
- le déverrouillage de la branche de commande (B1) est provoqué lors d'une première application d'un effort d'actionnement (F1) sur la branche de commande (B1).

4. Ensemble (10) selon la revendication 3, **caractérisé en ce que** :
- la branche de commande (B1) s'étend, depuis une extrémité avant (56) de la branche d'actionnement (B2) ; et
- le dispositif de verrouillage (70) verrouille une extrémité libre opposée (66) de la branche de commande (B1).

5. Ensemble (10) selon la revendication 4, **caractérisé en ce que** :
- le dispositif de verrouillage (70) comporte une languette escamotable (72) de verrouillage qui comporte un trou (78) dans lequel est reçue ladite extrémité libre (66) de la branche de commande (B1) lorsque cette dernière (B1) est dans sa position angulaire initiale de livraison ; et
- la languette de verrouillage (72) comporte un bec (82) de commande de son déverrouillage sur lequel l'organe d'actionnement (100) agit lors d'une première application d'un effort d'actionnement (F1) pour libérer ladite extrémité libre (66).

6. Ensemble (10) selon la revendication 5, **caractérisé en ce que** la languette de verrouillage (72) est réalisée en une seule pièce avec la lame de commande (14).

7. Ensemble (10) selon la revendication 4, **caractérisé en ce que** la branche de commande (B1) s'étend longitudinalement d'avant vers l'arrière au-dessus de la branche d'actionnement (B2).

8. Ensemble (10) selon la revendication 7, **caractérisé en ce que** la branche de commande (B1) est une branche rigide formant levier de commande du basculement de la branche d'actionnement (B2).

9. Ensemble (10) selon l'une quelconque des revendications précédentes, **caractérisé en ce que** le commutateur électrique (12) comporte un boîtier (16) qui loge ledit organe de déclenchement (24) et qui est apte à être fixé sur un support, notamment sur une plaque à circuits imprimés.

10. Ensemble (10) selon la revendication 9, **caractérisé en ce que** la branche de fixation (B3) de la lame de commande (14) est fixée au boitier (16) du commutateur électrique (12) ou est apte à être fixée sur ladite plaque à circuits imprimés.

11. Ensemble (10) selon l'une quelconque des revendications précédentes, **caractérisé en ce que** le commutateur électrique (12) comporte :
- un poussoir (40) d'actionnement de l'organe de déclenchement (24) ; et
- un organe (28), distinct de l'organe de déclenchement (24), de rappel élastique de l'organe de déclenchement (24) vers une position de repos dans laquelle le commutateur électrique (12) est dans son état libre ouvert.

12. Agencement d'un ensemble (10) selon l'une quelconque des revendications 2 à 11 pour l'actionnement du commutateur électrique (12), **caractérisé en ce qu'**il comporte un organe d'actionnement (100) qui est mobile par rapport à la branche de commande (B1), entre :
- une position de repos ;
- une position intermédiaire dans laquelle il coopère avec le dispositif de verrouillage (70) pour, si nécessaire, provoquer le déverrouillage de la lame de commande (14) ; et
- une position active dans laquelle la lame de commande (14) maintient le commutateur électrique (12) dans son état ouvert.

13. Procédé de test d'un ensemble selon l'une quelconque des revendications 1 à 11, **caractérisé en ce qu'**il consiste à :
- a) fabriquer un ensemble (10) selon l'une quelconque des revendications 1 à 11;
- b) fixer un tel ensemble (10) sur une face supérieure d'un sous-ensemble, par exemple sur la face supérieure d'une plaque à circuits imprimés, dans un état dans lequel la lame de commande (14) est dans sa position initiale de livraison ;
- c) agir sur la lame de commande (14) en lui appliquant un effort d'actionnement pour provoquer le déverrouillage de la lame de commande (14) et provoquer un changement d'état du commutateur électrique (12) ;
- d) effectuer des opérations de test du bon fonctionnement de l'ensemble (10), du commutateur électrique (12), et/ou d'un appareil équipé de l'ensemble pour en commander au moins une fonction ;
- e) procéder à nouveau au verrouillage de la lame de commande (14) dans sa position initiale de livraison de l'ensemble (10).

## Patentansprüche

1. Anordnung (10), die Folgendes umfasst:
- einen elektrischen Schalter (12), der ein Auslöseelement (24) umfasst; und
- ein elastisch verformbares Plättchen (14) zum Steuern der Zustandsänderung des elektrischen Schalters (12) als Reaktion auf das Aufbringen einer Betätigungskraft (F2) auf das Steuerplättchen (14),
und wobei (10) das Steuerplättchen (14) Folgendes aufweist:
- einen Abschnitt (B3) zum Befestigen des Steuerplättchens (14) relativ zu dem Auslöseelement (24);
- einen Betätigungsabschnitt (B2), dessen hinteres Ende (54) mit dem Befestigungsabschnitt (B3) verbunden ist und der in Abwesenheit einer Aufbringung der Betätigungskraft das Auslöseelement (24) des elektrischen Schalters (12) in einer Richtung beansprucht, die der Schließung des elektrischen Schalters (12) entspricht; und
-- einen Steuerabschnitt (B1), der mit dem Betätigungsabschnitt (B2) verbunden ist und der, unter der Aufbringung einer durch ein Betätigungselement (100) auf ihn aufgebrachten Betätigungskraft (F2) um eine orthogonale Achse (P) herum in die Betätigungsrichtung (A) des Auslöseelements (24) schwenkt, um ein Kippen des Betätigungsabschnitts (B2) gegen seine Elastizität zu verursachen, um den elektrischen Schalter (12) in einem frei geöffneten Zustand zu halten,
**dadurch gekennzeichnet, dass** die Anordnung (10) eine Sperrvorrichtung (70) des Steuerplättchens (14) in einer Ausgangsposition einer Lieferung der Anordnung (10) umfasst, in der der Betätigungsabschnitt (B2) das Auslöseelement (24) des elektrischen Schalters (12) nicht beansprucht, der sich in seinem geöffneten Zustand befindet.

2. Anordnung (10) nach Anspruch 1, **dadurch gekennzeichnet, dass** die Entsperrung des Steuerplättchens (14) während einer ersten Aufbringung einer Betätigungskraft (F1) auf das Steuerplättchen (14) verursacht wird.

3. Anordnung (10) nach Anspruch 2, **dadurch gekennzeichnet, dass**:
- die Sperrvorrichtung (70) den Steuerabschnitt (B1) des Steuerplättchens (14) in einer winkelförmigen Ausgangsposition der Lieferung der Anordnung (10) umfasst, in der der Betätigungsabschnitt (B2) das Auslöseelement (24) des elektrischen Schalters (12) nicht beansprucht, der sich in seinem geöffneten Zustand befindet; und
- die Entsperrung des Steuerabschnitts (B1) während einer ersten Aufbringung einer Betätigungskraft (F1) auf den Steuerabschnitt (B1) verursacht wird.

4. Anordnung (10) nach Anspruch 3, **dadurch gekennzeichnet, dass**:
- der Steuerabschnitt (B1) sich von einem vorderen Ende (56) des Betätigungsabschnitts (B2) erstreckt; und
- die Sperrvorrichtung (70) ein gegenüberliegendes freies Ende (66) des Steuerabschnitts (B1) sperrt.

5. Anordnung (10) nach Anspruch 4, **dadurch gekennzeichnet, dass**:
- die Sperrvorrichtung (70) eine einziehbare Sperrlasche (72) umfasst, die ein Loch (78) aufweist, in dem das freie Ende (66) des Steuerabschnitts (B1) aufgenommen wird, wenn sich dieser (B1) in seiner winkelförmigen Ausgangsposition der Lieferung befindet; und
- die Sperrlasche (72) eine Spitze (82) zum Steuern ihrer Entriegelung umfasst, auf die das Betätigungselement (100) während einer ersten Aufbringung einer Betätigungskraft (F1) zum Freigeben des freien Endes (66) wirkt.

6. Anordnung (10) nach Anspruch 5, **dadurch gekennzeichnet, dass** die Sperrlasche (72) einstückig mit dem Steuerplättchen (14) ausgeführt wird.

7. Anordnung (10) nach Anspruch 4, **dadurch gekennzeichnet, dass** sich der Steuerabschnitt (B1) der Länge nach von vorne nach hinten oberhalb des Betätigungsabschnitts (B2) erstreckt.

8. Anordnung (10) nach Anspruch 7, **dadurch gekennzeichnet, dass** der Steuerabschnitt (B1) ein starrer Abschnitt ist, der einen Steuerhebel zum Kippen des Betätigungsabschnitts (B2) ausbildet.

9. Anordnung (10) nach einem der vorhergehenden Ansprüche, **dadurch gekennzeichnet, dass** der elektrische Schalter (12) ein Gehäuse (16) umfasst, das das Auslöseelement (24) unterbringt und das geeignet ist, an einem Träger, insbesondere an einer Leiterplatte, befestigt zu werden.

10. Anordnung (10) nach Anspruch 9, **dadurch gekennzeichnet, dass** der Befestigungsabschnitt (B3) des Steuerplättchens (14) an dem Gehäuse (16) des elektrischen Schalters (12) befestigt ist oder geeignet ist, mit an der Leiterplatte befestigt zu werden.

11. Anordnung (10) nach einem der vorhergehenden Ansprüche, **dadurch gekennzeichnet, dass** der elektrische Schalter (12) Folgendes umfasst:
- eine Druckvorrichtung (40) zum Betätigen des Auslöseelements (24); und
- ein Element (28), das von dem Auslöseelement (24) getrennt ist, zur elastischen Rückstellung des Auslöseelements (24) in eine Ruheposition, in der sich der elektrische Schalter (12) in seinem frei geöffneten Zustand befindet.

12. Konfiguration einer Anordnung (10) nach einem der Ansprüche 2 bis 11 zum Betätigen des elektrischen Schalters (12), **dadurch gekennzeichnet, dass** sie ein Betätigungselement (100) umfasst, das relativ zu dem Steuerabschnitt (B1) zwischen Folgendem bewegbar ist:
- einer Ruheposition;
- einer Zwischenposition, in der sie mit der Sperrvorrichtung (70) zusammenwirkt, um, falls erforderlich, die Entsperrung des Steuerplättchens (14) zu verursachen; und
- einer aktiven Position, in der das Steuerplättchen (14) den elektrischen Schalter (12) in seinem geöffneten Zustand hält.

13. Verfahren zum Testen einer Anordnung nach einem der Ansprüche 1 bis 11, **dadurch gekennzeichnet, dass** es aus Folgendem besteht:
- a) Herstellen einer Anordnung (10) nach einem der Ansprüche 1 bis 11
- b) Befestigen einer derartigen Anordnung (10) an einer Oberseite einer Untereinheit, beispielsweise an der Oberseite einer Leiterplatte, in einem Zustand, in dem sich das Steuerplättchen (14) in seiner Ausgangsposition der Lieferung befindet;
- c) Wirken auf das Steuerplättchen (14), indem eine Betätigungskraft auf dieses zum Entsperren des Steuerplättchens (14) aufgebracht wird, und Verursachen einer Zustandsänderung des elektrischen Schalters (12);
- d) Durchführen von Vorgängen zum Testen des korrekten Betriebs der Anordnung (10), des elektrischen Schalters (12) und/oder einer mit der Anordnung ausgestatteten Vorrichtung zum Steuern wenigstens einer Funktion davon;
- e) erneutes Vornehmen der Sperrung des Steuerplättchens (14) in seiner Ausgangsposition der Lieferung der Anordnung (10).

## Claims

1. Assembly (10) comprising:
- an electrical switch (12) comprising a trip member (24); and
- an elastically deformable blade (14) for controlling the change of state of the electrical switch (12) in response to the application of an actuation effort (F2) on the control blade (14),
and in which (10) the control blade (14) comprises:
-- a branch (B3) for fixing the control blade (14) with respect to the trip member (24);
-- an actuation branch (B2), a rear end (54) of which is linked to the fixing branch (B3) and which, in the absence of application of an actuation effort, stresses the trip member (24) of the electrical switch (12) in a direction corresponding to the closure of the electrical switch (12); and
-- a control branch (B1) which is linked to the actuation branch (B2) and which, under the application of an actuation effort (F2) which is applied to it by an actuation member (100), pivots about an axis (P) orthogonal to the direction (A) of actuation of the trip member (24) to provoke a tilting of the actuation branch (B2) against its elasticity to keep the electrical switch (12) in an open free state,
**characterized in that** the assembly (10) comprises a locking device (70) for locking the control blade (14) in an initial position of delivery of the assembly (10) in which the actuation branch (B2) does not stress the trip member (24) of the electrical switch (12) which is in its open state.

2. Assembly (10) according to Claim 1, **characterized in that** the unlocking of the control blade (14) is provoked upon a first application of an actuation effort (F1) on the control blade (14).

3. Assembly (10) according to Claim 2, **characterized in that**:
- the locking device (70) locks the control branch (B1) of the control blade (14) in an initial angular position of delivery of the assembly (10) in which the actuation branch (B2) does not stress the trip member (24) of the electrical switch (12) which is in its open state; and
- the unlocking of the control branch (B1) is provoked upon a first application of an actuation effort (F1) on the control branch (B1).

4. Assembly (10) according to Claim 3, **characterized in that**:
- the control branch (B1) extends, from a front end (56) of the actuation branch (B2); and
- the locking device (70) locks an opposite free end (66) of the control branch (B1).

5. Assembly (10) according to Claim 4, **characterized in that**:
- the locking device (70) comprises a retractable locking tongue (72) which comprises a hole (78) in which said free end (66) of the control branch (B1) is received when said control branch (B1) is in its initial angular position of delivery; and
- the locking tongue (72) comprises a latch (82) controlling the unlocking thereof on which the actuation member (100) acts upon a first application of an actuation effort (F1) to release said free end (66).

6. Assembly (10) according to Claim 5, **characterized in that** the locking tongue (72) is produced in a single piece with the control blade (14).

7. Assembly (10) according to Claim 4, **characterized in that** the control branch (B1) extends longitudinally from front to rear above the actuation branch (B2).

8. Assembly (10) according to Claim 7, **characterized in that** the control branch (B1) is a rigid branch forming a lever controlling the switch over of the actuation branch (B2).

9. Assembly (10) according to any one of the preceding claims, **characterized in that** the electrical switch (12) comprises a housing (16) which houses said trip member (24) and which can be fixed onto a support, for example onto a printed circuit board.

10. Assembly (10) according to Claim 9, **characterized in that** the fixing branch (B3) of the control blade (14) is fixed to the housing (16) of the electrical switch (12) or can be fixed onto said printed circuit board.

11. Assembly (10) according to any one of the preceding claims, **characterized in that** the electrical switch (12) comprises:
- a pushbutton (40) for actuating the trip member (24); and
- an elastic return member (28), distinct from the trip member (24), for returning the trip member (24) to a position of rest in which the electrical switch (12) is in its open free state.

12. Arrangement of an assembly (10) according to any one of Claims 2 to 11 for actuating the electrical switch (12), **characterized in that** it comprises an actuation member (100) which is movable with respect to the control branch (B1), between:
- a position of rest;
- an intermediate position in which it cooperates with the locking device (70) to, if necessary, provoke the unlocking of the control blade (14); and
- an active position in which the control blade (14) keeps the electrical switch (12) in its open state.

13. Method for testing an assembly according to any one of Claims 1 to 11, **characterized in that** it consists in:
- a) manufacturing an assembly (10) according to the invention;
- b) fixing such an assembly (10) onto a top face of a subassembly, for example onto the top face of a printed circuit board, in a state in which the control blade (14) is in its initial position of delivery;
- c) acting on the control blade (14) by applying to it an actuation effort to provoke the unlocking of the control blade (14) and provoke a change of state of the electrical switch (12);
- d) performing operations to test the correct operation of the assembly (10), of the electrical switch (12), and/or of a unit equipped with the assembly to control at least one function thereof;
- e) proceeding once again to lock the control blade (14) in its initial position of delivery of the assembly (10).
